# EUROPEAN PATENT SPECIFICATION

(11) **EP 3 021 201 B1**
(45) Date of publication and mention of the grant of the patent: **31.10.2018**
(21) Application number: 15194301.6
(22) Date of filing: 23.03.2010
(51) Int. Cl.: G06F 3/041, G06F 3/01

(54) **TOUCH PANEL ASSEMBLY WITH HAPTIC EFFECTS**
BERÜHRUNGSBILDSCHIRMANORDNUNG MIT HAPTISCHEN EFFEKTEN
ENSEMBLE PANNEAU TACTILE AVEC EFFETS HAPTIQUES

(30) Priority: 23.03.2009 US 408824; 08.10.2009 US 249873 P
(43) Date of publication of application: 18.05.2016
(62) Divisional of application: 10756728.1
(73) Proprietor: Methode Electronics, Inc., Carthage, IL 62321 (US)
(72) Inventor: Schmidt, Robert, Livonia, MI Michigan 48154 (US)
(74) Representative: Prinz & Partner mbB

(56) References cited:
- EP-A1- 1 450 247
- EP-A2- 1 560 102
- US-A1- 2007 057 927

## Description

### Field of the Invention

The invention relates to systems with haptic effects. In particular, the invention relates to touch panels with haptic feedback.

### Background of the Invention

In many present day situations, a person has to adjust various functions and operations of several different electrical and mechanical devices. For example, the driver of a car while driving may have to adjust or control a heating and cooling system, an audio entertainment system, windows, locks, a cruise control system and possibly a navigation system. Conventionally, the user would use buttons, switches, knobs, and other similar mechanical controls to adjust the various functions or operations of these devices. However, with the increased number of controllable devices, along with the increased complexity of each individual device, a person may be required to provide many different inputs through several different buttons, switches, knobs, and other mechanical controls.

To replace the many, separate, and different mechanical controls and to simplify and enhance the control of these many devices, a single aggregate instrument that can relay commands to several devices is often employed, such as a touch panel. By using a touch panel, the user can adjust several different devices by interacting with a hierarchical menu shown through the touch panel from an underlying display to select a particular device and to select a particular function associated with that device.

The touch panel replaces mechanical buttons and switches but typically does not provide the same tactile feedback as a mechanical button or switch. Thus, to enhance the user's interaction with the touch panel, feedback to the user may be provided through visual, auditory, kinesthetic, and/or tactile cues. Kinesthetic feedback, such as active and resistive force feedback, and tactile feedback, such as vibration, texture, and heat, is collectively referred to as "haptic feedback." Haptic feedback can be used to convey physical force sensations to the user, and generally, the physical forces simulate actuating a mechanical button or switch and provide the user with an indication that the user's input has been accepted.

Conventional haptic feedback can be provided by linear actuators, piezoelectric films, or oscillating mass actuators. Linear actuators provide linear motion using an electromagnetic actuator and simulate a push response. In one conventional system, four individual linear actuators are placed at the four corners of a touch panel. Based on the user's interaction with the touch panel, the four individual actuators will simultaneously impart a slight linear motion to the touch panel so that the user perceives a push response. However, conventional haptic feedback systems using four individual linear actuators are costly to manufacture and difficult to manufacture because such systems require precise alignment of the individual linear actuators to each other for proper movement. Also, linear actuators may not provide an audible feedback that the user's input has been received or accepted.

Haptic feedback is also provided by using piezoelectric films. Piezoelectric films are typically placed over a touch panel and vibrate in response to a touch by the user. Thus, it vibrates or flexes the surface of the touch panel. However, conventional haptic feedback systems using piezoelectric film that vibrate or flex a surface often experience premature failure due to surface stress cracks or subsurface solder joint failures. Also, for certain applications, vibrating the touch panel and its underlying display is not practical.

Furthermore, haptic feedback is also provided by oscillating mass actuators. Oscillating mass actuators shake a component, such as the touch panel and its display, or in some cases, the entire assembly. However, the entire mass of a touch panel assembly cannot be vibrated or pulsed with conventional mounting and assembly systems. Also, similar to systems using piezoelectric films, in certain applications, it may not be practical to vibrate or move the touch panel system and its underlying display.

Lastly, conventional haptic feedback moves the entire touch panel assembly, which can damage the touch panel or its underlying display. In particular, frequent, small movements can damage the fragile electronic components within the touch panel or its underlying display.

Thus, there is a need for a system that provides haptic feedback at reduced cost, simplifies manufacturing of devices with haptic feedback, and reduces premature component failure. Also, there is a need for a system that provides haptic feedback but avoids moving an entire touch panel assembly.

EP1560102 discloses a touchscreen with spring-controlled haptic feedback. US2007/057927 discloses an input device for a vehicle including a housing, a display a touchscreen and an actuator. EP1450247 discloses a human-computer interface with force feedback for a pressure pad.

### Summary of the Invention

The invention is defined in independent claim 1. Preferred embodiments thereof are presented in the dependent claims.

Other objects, advantages and salient features of the invention will become apparent from the following detailed description, which, taken in conjunction with the annexed drawings, discloses embodiments of the invention, as well as examples which are not part of the invention.

### Brief Description of the Drawings

A more complete appreciation of the invention and many of the attendant advantages thereof will be readily obtained as the same becomes better understood by reference to the following detailed description when considered in connection with the accompanying drawings, wherein:
FIG. 1 is an exploded perspective view of a touch panel assembly with haptic effects;
FIG. 2A is a front elevational view of the touch panel assembly illustrated in FIG. 1;
FIG. 2B is a rear elevational view of the touch panel assembly illustrated in FIG. 1;
FIG. 2C is a side elevational sectional view along line 2C-2C of the touch panel assembly illustrated in FIG. 2B;
FIG. 2D is a top plan sectional view along line 2D-2D of the touch panel assembly illustrated in FIG. 2B;
FIG. 3 is an exploded rear perspective view of the touch panel assembly illustrated in FIG. 1;
FIG. 4 is a partial sectional view in detail of the touch panel assembly illustrated in FIG. 1;
FIG. 5 is a partial sectional view in detail of the touch panel assembly illustrated in FIG. 1;
FIG. 6 is a partial sectional view in detail of the touch panel assembly illustrated in FIG. 1;
FIG. 7 is a partial sectional view in detail of a flex arm of a touch panel assembly according to another example;
FIG. 8 is a partial sectional view in detail of a bezel and a rear cover of a touch panel assembly according to yet another example;
FIG. 9 is a plan view of an actuator of a touch panel assembly according to a further example;
FIG. 10 is a partial sectional view in detail of the touch panel assembly according to a further example;
FIG. 11 is another partial sectional view in detail of the touch panel assembly illustrated in FIG. 10; [0030] FIG. 12 is a perspective view of an assembly with haptic effects according to an exemplary embodiment of the invention;
FIG. 13 is a perspective view of a display portion of the assembly illustrated in FIG, 12;
FIG. 14 is a sectional view of the display portion illustrated in FIG. 13;
FIG. 15 is an exploded perspective view of the display portion illustrated in FIG. 13 with an exploded view of a touch screen assembly of the display portion;
FIG. 16 is a perspective view of a flex frame of the display portion illustrated in FIG. 13;
FIG. 17 is a schematic of the flex frame illustrated in FIG. 16;
FIG. 18 is a plan view of the flex frame illustrated in FIG. 16 with haptic actuators;
FIG. 19 is a partial perspective view in detail of the flex frame illustrated in FIG. 18;
FIG. 20 is a plan view of one of the haptic actuators illustrated in FIG. 18;
FIG. 21 is a sectional perspective view of the display portion illustrated in FIG. 13;
FIG. 22 is a sectional perspective view of the display portion illustrated in FIG. 13;
FIG. 23 is a plan view of a flex frame according to another example;
FIG. 24 is a perspective view of a haptic actuator of the flex frame illustrated in FIG. 23;
FIG. 25 is a perspective view of the haptic actuator illustrated in FIG. 24;
FIG. 26 is a plan view of a flex frame according to yet another embodiment of the invention;
FIG. 27 is a plane view of a haptic actuator of the flex frame illustrated in FIG. 26;
FIG. 28 is a rear perspective view of the assembly illustrated in FIG. 12;
FIG. 29 is an exploded perspective view of a touch panel portion of the assembly illustrated in FIG. 12;
FIG. 30 is a sectional perspective view of the touch panel portion illustrated in FIG. 29;
FIG. 31 is a rear view of the touch panel portion illustrated in FIG. 29;
FIG. 32 is a sectional view of the touch panel portion illustrated in FIG. 29;
FIG. 33 is a sectional view of the touch panel portion illustrated in FIG. 29;
FIG. 34 is a partial sectional view of the touch panel portion illustrated in FIG, 29;
FIG. 35 is a partial sectional view of the touch panel portion illustrated in FIG. 29; and
FIG. 36 is a partial sectional view of the touch panel portion illustrated in FIG, 29.

### Detailed Description of the Invention

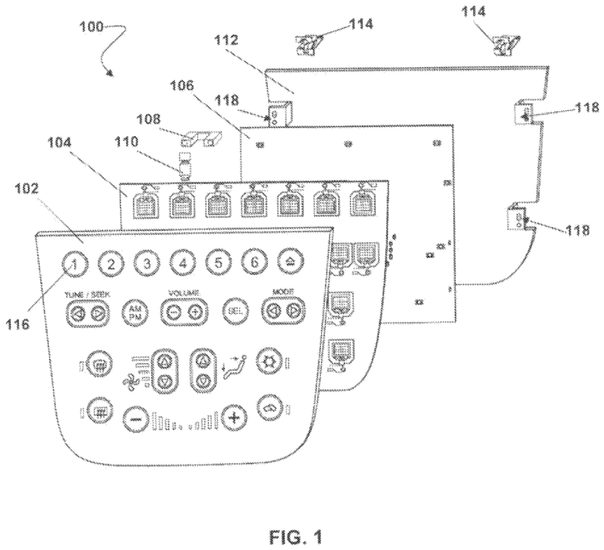

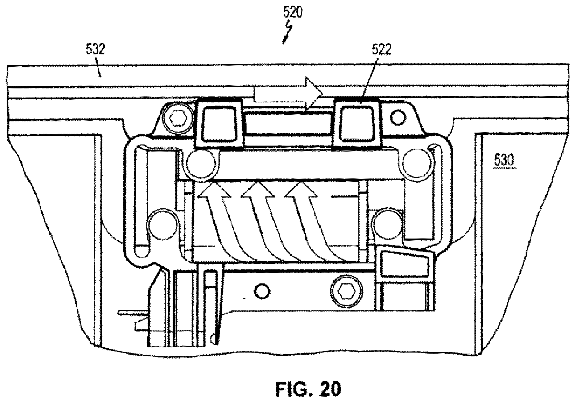

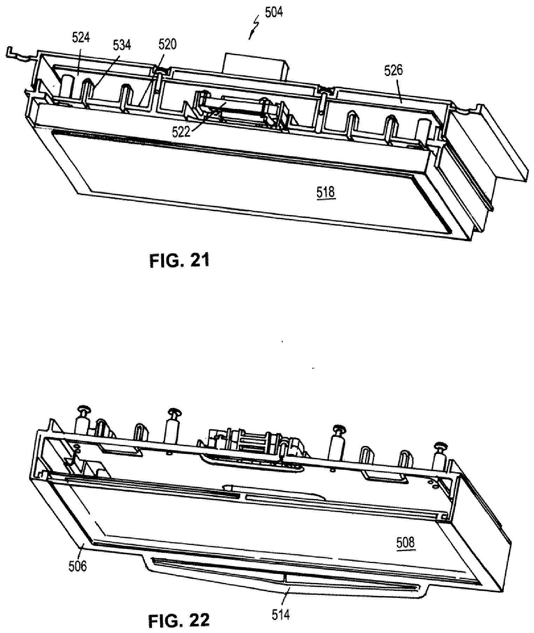

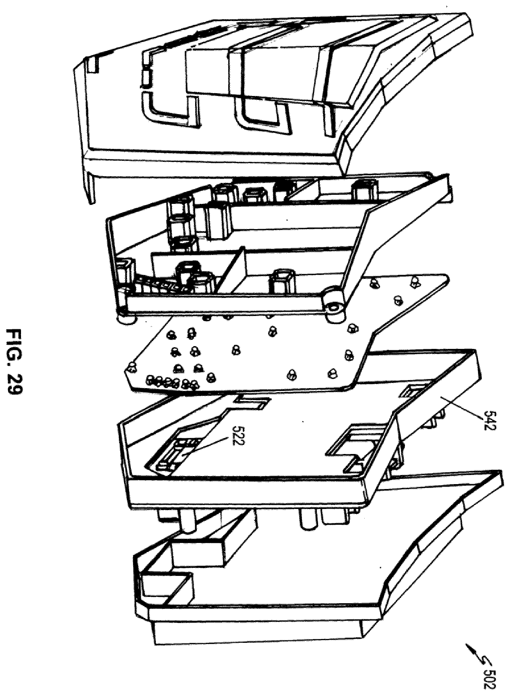

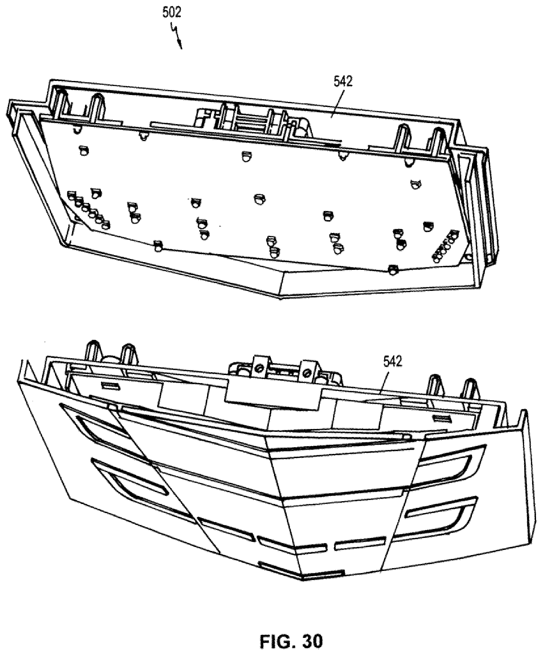

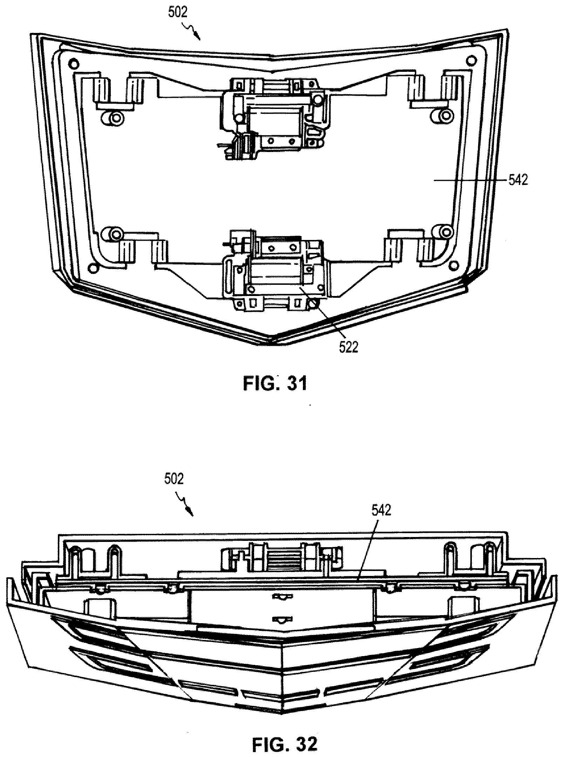

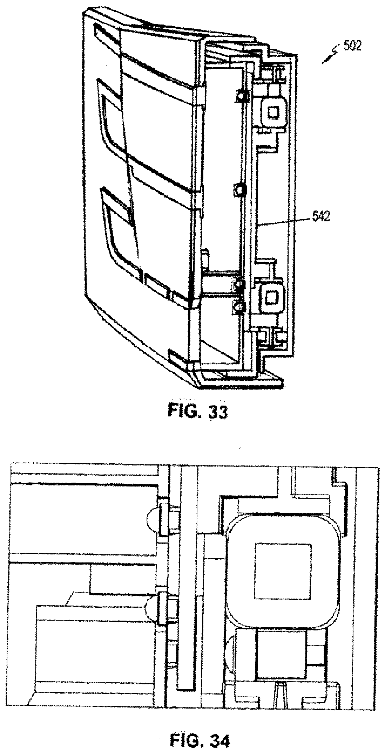

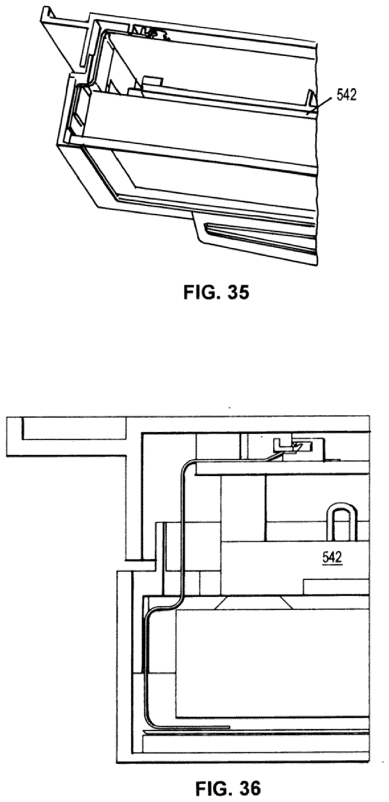

Referring to FIGS. 1 to 36, the invention can provide a touch panel assembly 100 with haptic effects and a method of manufacturing the touch panel assembly 100 with haptic effects. The touch panel assembly 100 can provide haptic feedback when the user manipulates an input device 116. The invention can also provide an assembly 500 that avoids moving an entire touch panel assembly.

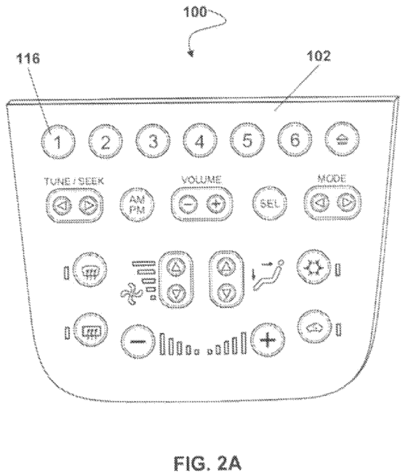

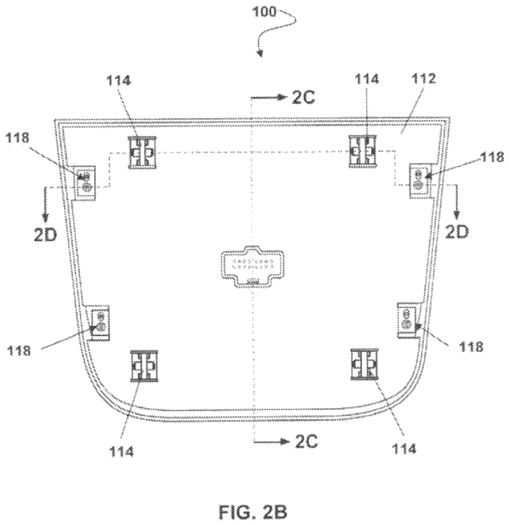

Referring to FIGS. 1 and 2A-2D, the touch panel assembly 100 according to one example is shown. In the depicted example, the touch panel assembly 100 can be installed in a dashboard of a vehicle.

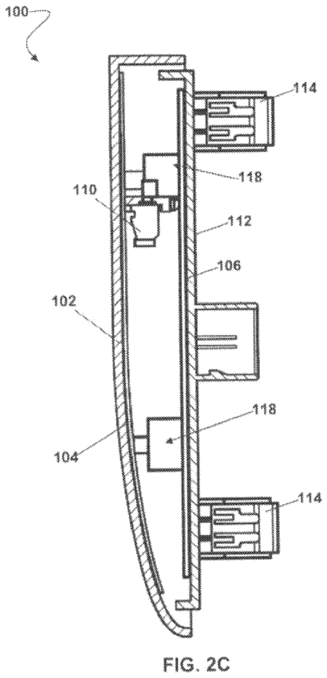

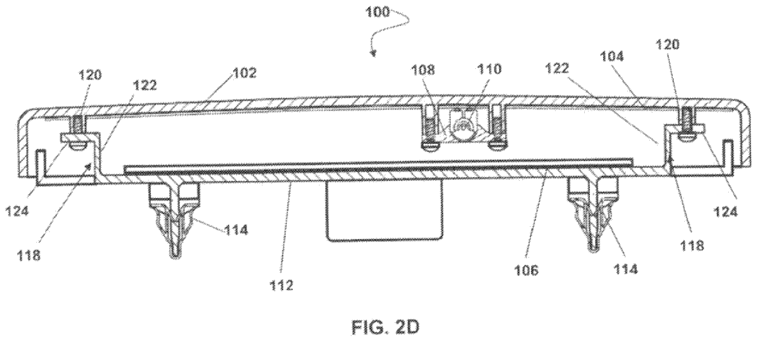

In the example shown, the touch panel assembly 100 can include a bezel 102, a sensor circuit board 104, an interface circuit board 106, a retainer bracket 108, a haptic effect generator 1 10, a rear cover 112, and one or more mountings 1 14. Terms such as "front," "forward," "back," "rear," "to the right," "to the left," and other similar terms are not intended to limit the invention. Instead, such terms are used to facilitate describing the positions of components relative to other components. As best shown in the Figures 2C and 2D, the bezel 102, the sensor circuit board 104, the interface circuit board 106, and the rear cover 112 can be disposed in layers with the bezel 102 and the rear cover 1 12 substantially encasing the sensor circuit board 104, the interface circuit board 106, the retainer bracket 108, and the haptic effect generator 110 to form the touch panel assembly 100.

The bezel 102 can provide a surface that a user interacts with to provide an input to the touch panel assembly 100. The bezel 102 can include at least one input device 116. The input device 116 can be pressure sensitive through resistive sensors, electrically sensitive through capacitive sensors, acoustically sensitive through surface acoustic wave sensors, photo sensitive through infrared sensors, and the like. In the example shown, the input device 116 can be depressed by the user. In other embodiments, the input device 116 can be a switch, rotary knob, pull switch, or some other input device that can be implemented with the touch panel assembly 100. Furthermore, the bezel 102 can be marked with words, letters, numbers, figures, or other indicia to indicate the function of the input device 116. The bezel 102 can be made from any suitably rigid material, including, but not limited to, plastics, metals, leathers, glass, wood, combinations of the aforementioned, and other similar materials. The choice of material may also be suitable for the type of input device 116 used with the touch panel assembly 100. For example, in the example shown, plastics are used because they have the necessary elastic flexibility that can be used with a depressible input device 116.

Also, although the depicted example has a bezel 102, in other examples, the bezel 102 can be replaced with a touch screen, one or more touch switches, one or more touch pads, and other similar devices that can accept an input from a user. The touch screen, touch switches, touch pads, and the like can be made transparent or translucent and placed over a display device that generates graphical images. The display device can be a liquid crystal display, a plasma display, an electroluminescent display, a light emitting diode display, or some other device for displaying images, such that the user responds to images to provide an input to the touch panel assembly 100 instead of the indicia of a bezel 102.

Disposed behind the bezel 102 may be the sensor circuit board 104. The sensor circuit board 104 can include the corresponding and necessary electrical components, electronics, mechanical components, and other devices that interact with the input device 116 to transform the user's input into an electrical, electromechanical, or mechanical signal suitable for use by the touch panel assembly 100. The sensor circuit board 104 can be made from a suitable material that provides mechanical support and a mounting surface for the electrical components, electronics, mechanical components, and other devices necessary for the input device 116. As best seen in FIGS. 2C and 2D, the sensor circuit board 104 of the depicted example can be disposed immediately adjacent to a surface of the bezel 102 opposite the surface with the input devices 116. Also, in the example shown, the sensor circuit board 104 can be a dielectric substrate with electronics on the substrate to transform the actuating of an input device 116 into an electrical signal.

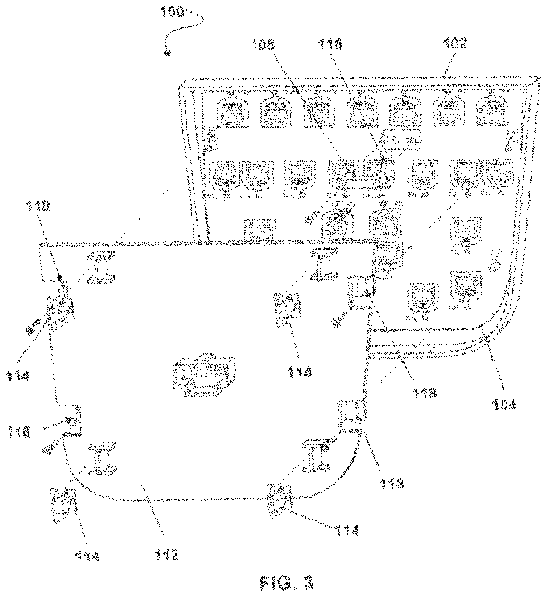

The interface circuit board 106 may be disposed adjacent to and to the rear of the sensor circuit board 104. In other examples, the interface circuit board 106 and the sensor circuit board 104 can be formed as a single circuit board. Alternatively, in other examples, the touch panel assembly 100 can include more than one sensor circuit board 104 and more than one interface circuit board 106. The interface circuit board 106 includes electrical components, electronics, mechanical components, and other devices that can transform or relay the signal received from the sensor circuit board 104 to the controlled device, such as a component of an audio entertainment system or a component of a heating and cooling system. Similar to the sensor circuit board 104, the interface circuit board 106 can be made from a suitable material that provides mechanical support and a mounting surface for the electrical components, electronics, mechanical components, and other necessary devices. As best seen in FIGS. 2C and 2D and 3 the interface circuit board 106 of the depicted example may be disposed immediately adjacent to a surface of the rear cover 112. Also, in the example shown, the interface circuit board 106 can be a dielectric substrate with electronics on the substrate to transform or relay the electric signal from the sensor circuit board 104 to a device to be controlled by the touch panel assembly 100.

Turning to FIGS. 2C, 2D, and 3, the rear cover 112 provides protection and mechanical support. The rear cover 112 can be made from any suitable rigid material, such as, but not limited to, plastics, metals, leathers, glass, wood, combinations of the aforementioned, and other similar materials. In the example shown, the rear cover 112 can join with the bezel 102 to substantially encompass the sensor circuit board 104, the interface circuit board 106, the retainer bracket 108, and the haptic effect generator 110 to form the touch panel assembly 100.

As best shown in FIGS. 2C and 2D, the rear cover 112 can be coupled to the bezel 102 by at least one flex arm assembly 118. The flex arm assembly 118 can include a coupling 120 to couple the bezel 102 to the rear cover 112 and a flexible arm portion 122. The flexible arm portion 122 allows the bezel 102 to elastically move relative to the rear cover 112. The flexible arm portion 122 can elastically bend when the haptic effect generator 110 is actuated. In the example shown, the coupling 120 is a screw, and the flexible arm portion 122 is a portion of the rear cover 112 formed substantially perpendicular to the rear cover 112. The flexible arm portion 122 can also have a coupling portion 124 extending from it to engage the coupling 120. Thus, when an input device 116 on the bezel 102 is actuated, a signal can be sent to the haptic effect generator 110. The signal sent to the haptic effect generator 110 can cause it to impart a slight movement to the bezel 102 which informs the user that his manipulation of the input device 116 is being processed by the touch panel assembly 100. The movement caused by the haptic effect generator 110 can be limited by the flexible arm portion 122 of the flex arm assembly 118, and the flexible arm portion 122 can elastically return the bezel 102 to substantially its original position relative to the rear cover 112, i.e., the position before the movement caused by the haptic effect generator 110.

Furthermore, the rear cover 112 can have at least one mounting 114 to couple the touch panel assembly 100 to another structure 126. In the example shown, the rear cover 112 can provide a surface for one or more mountings 114 to install the touch panel assembly 100 into the dashboard 126 of a vehicle. The one or more mountings 114 can be screws, nuts and bolts, rivets, press fittings, and other similar couplings. In the depicted example, the mountings 114 are spring clips. Because the rear cover 112 has at least one flex arm assembly 1 18 that couples to the bezel 102 and at least one mounting 114 that couples the touch panel assembly 100 to another structure, the rear cover 112 can be coupled to a conventional control panel to provide the conventional control panel assembly with at least one flex arm assembly 118. Also, the rear cover 112 can be adapted for use with a wide variety of haptic effect generators 110 thus optimizing the balance between cost and performance. Furthermore, the rear cover 112 can provide a single component transition between the fixed structure 126, such as the dashboard, and the moving surface, such as the bezel 102.

As best shown in FIG. 2D, the retainer bracket 108 can couple the haptic effect generator 110 to the bezel 102. The haptic effect generator 110 can provide a haptic effect in response to the user manipulating an input device 116 of the bezel 102. The haptic effect generator 110 can provide linear motion, circular motion, or non-linear motion. The motion can simulate a response to a push of a mechanical button or other similar mechanical input devices. The motion provided by the haptic effect generator 110 can be caused by several different methods, such as, but not limited to, electrical, electromechanical, hydraulic, pneumatic, or mechanical. The haptic effect generator 110 can be active or passive. Active actuators can include, for example, linear current control motors, stepper motors, pneumatic/hydraulic active actuators, voice coil actuators, and other similar devices. Passive actuators can include, but are not limited to, dissipative passive actuators, linear magnetic particle brakes, linear friction brakes, pneumatic/hydraulic passive actuators, and other similar devices. Also, the haptic effect generator 110 can be, but not limited to, a solenoid, a linear resonance actuator, an eccentric rotary mass motor, a linear actuator such as the commercially available "Immersion A100," piezoelectric film, combinations of the aforementioned, or any other device that can produce a haptic effect.

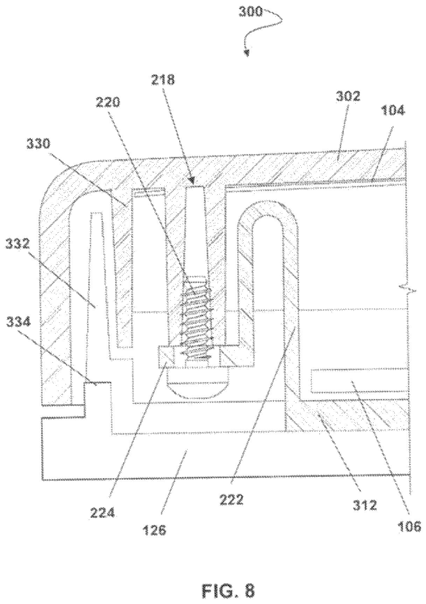

To simplify the description without intending to limit the invention, the haptic effect generator 110 is described as providing a linear motion. In the example shown in FIGS. 1-6, the haptic effect generator 110 can include an eccentric rotary mass, while in the example shown FIGS. 8-10, the haptic effect generator 110 can include a linear actuator.

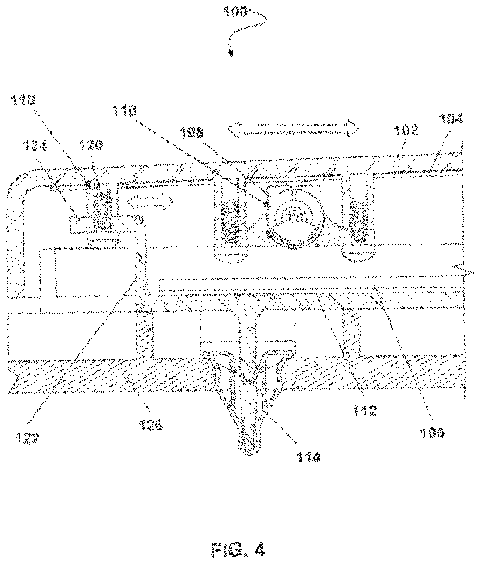

Referring to FIGS. 4-6, a sectional view of the touch panel assembly 100 is shown with the retainer bracket 108, the haptic effect generator 110, one flex arm assembly 118, and one mounting 114 shown in close proximity to each other to explain the operation of the example. In the example shown, the haptic effect generator 110 has an eccentric rotary mass. Turning to FIG. 4, the eccentric rotary mass of the haptic effect generator 110 is beginning to rotate clockwise, and the flexible arm portion 122 of the flex arm assembly 118 is shown in its substantially non-flexed state. The flexible arm portion 122 can flex either to its left or to its right, and thus, the bezel 102 can move either to its left or to its right.

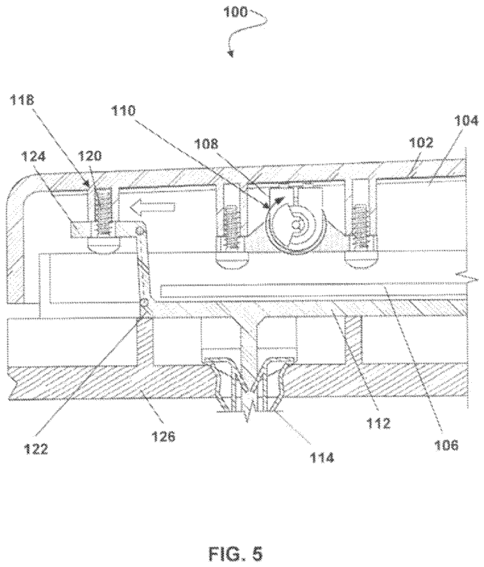

Turning to FIG. 5, the eccentric rotary mass has rotated further clockwise and is disposed mostly to the left of the haptic effect generator 110. Because the mass is positioned substantially to the left of the haptic effect generator 110, the haptic effect generator 110 can cause the bezel 102 to move to the left of the figure. However, the flexible arm portion 122 elastically limits the movement of the bezel 102 to the left.

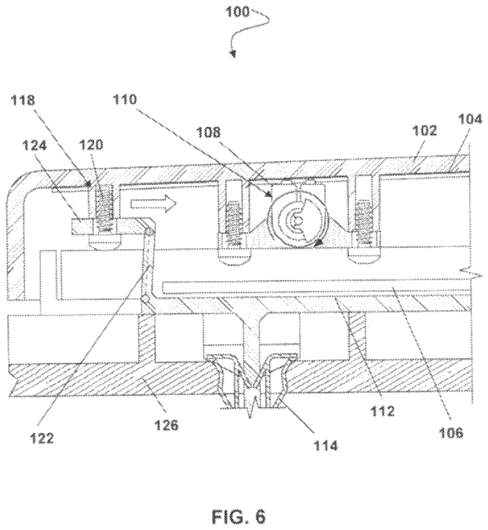

Turning to FIG. 6, the eccentric rotary mass has rotated further clockwise and is disposed mostly to the right of the haptic effect generator 110. Because the mass is positioned substantially to the right of the haptic effect generator 110, the haptic effect generator 110 can cause the bezel 102 to move to the right of the figure. As before, the flexible arm portion 122 elastically limits the movement of the bezel 102 to the right. Further movement of the rotary mass returns it to substantially its original position, and the flexible arm portion 122 substantially returns the bezel 102 to its original position relative to the rear cover 112.

To manufacture the touch panel assembly with haptic effects, a first surface can be provided. In the example shown in the figures, the first surface is a surface of the bezel 102. Next, a second surface can be provided, and a flexible arm portion 122 can be disposed on the second surface. Alternatively, in some examples, the flexible arm portion 122 can be disposed on the first surface. The flexible arm portion 122 can include a coupling portion 124. In the example shown, the second surface is a surface of the rear cover 112. Then, a coupling can couple the first surface with the second surface via the coupling portion 124. In the depicted example, the coupling is a screw that extends through the coupling portion 124 of the rear cover 112 to a screw hole in the bezel 102. Next, a haptic effect generator 110 can be disposed on one of the surfaces. In the example shown, the haptic effect generator 110 is attached to the bezel 102 by a retainer bracket 108. The steps are described as being performed in a particular order, but the order in which these steps are performed is not important and other orders may be suitable.

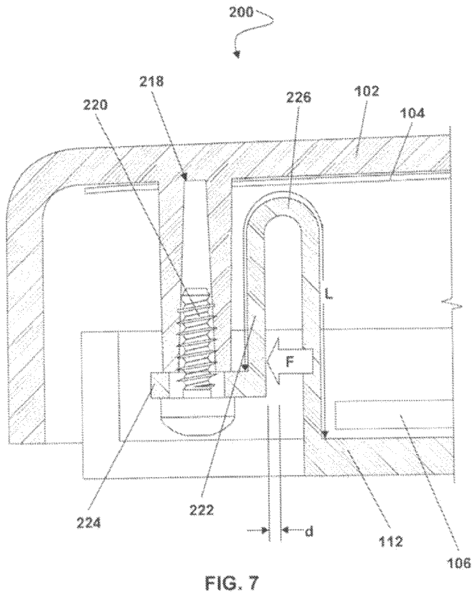

Referring to FIG. 7, another example of the flex arm assembly 218 is shown. The flex arm assembly 218 can include a coupling 220, a flexible arm portion 222, and a coupling portion 224. The coupling 220 and the coupling portion 224 are substantially similar to the coupling 120 and the coupling portion 124, respectively, of the touch panel assembly 100. Thus, a detailed description of the coupling 220 and the coupling portion 222 are omitted. However, unlike the flexible arm portion 122, the flexible arm portion 222 can include a loop 226. The loop 226 allows the geometry of the flexible arm portion 222 to be varied. For example, the length L can be varied. Varying the geometry of the flexible arm portion 222 generally changes the elastic force F generated by the deflection d of the flexible arm portion 222. The force can be calculated with the following equations: *k* = *F*/*d where F* = *(3dEI)*/*L³.* In the equations, k is the spring constant; F is the force; d is the deflection of the flexible arm portion 222; E is modulus of elasticity of the material used for the flexible arm portion 222; L is the length of the flexible arm portion; I is the moment of inertia and can be calculated by the equation *I = bh³*/ *12* for a rectangular section. In the equation *I* = *bh³*/*12,* b is the beam width, i.e., the width of a section of the flexible arm portion 222, and h is the beam thickness, i.e. , the height of a section of the flexible arm portion 222. Based on the equations above, length can be a critical variable in determining the elastic force generated by the deflection of the flexible arm portion 222.

Referring to FIG. 8, another example of the bezel 302 and rear cover 312 is shown. The flex arm assembly 218 described above is also shown. The bezel 302 can include a first baffle 330, and the rear cover 312 can include a second baffle 332. The first baffle 330, the second baffle 332, or both substantially prevents debris or fluid intrusion into the touch panel assembly 300. The second baffle 332 can be provided with a sealed seat 334 to provide further protection against debris and fluid. In the example shown, the first baffle 330 is placed inward of the second baffle 332. Also, the first baffle 330 and the second baffle 332 can be disposed substantially along the periphery of the bezel 302 and the rear cover 312, respectively.

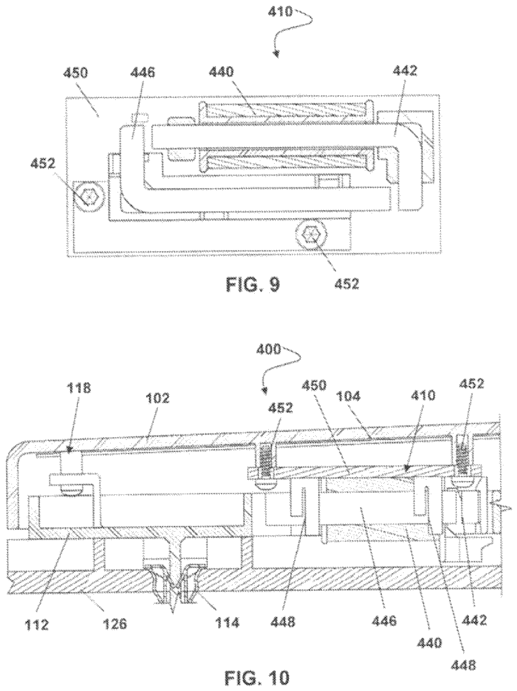

Referring to FIG. 9, an alternate example of a haptic effect generator 410 is shown. Unlike the haptic effect generator 110 of the touch panel assembly 100, the haptic effect generator 410 can include an integrated electromagnetic linear actuator. A description of an electromagnetic linear actuator is described in U.S. Patent Application Serial No. 11/969,071, filed January 3, 2008, entitled "Haptic Actuator Assembly and Method of Manufacturing a Haptic Actuator Assembly". In the embodiment depicted, the haptic effect generator 410 can have a coil 440, a core 442, and a ferrous body 446. The coil 440 can be made of an electrically conductive material wrapped around the core 442. The coil 440 can produce a magnetic field when an electrical current is applied to the coil 440. The core 442 can be made of a ferrous material or a material that can be magnetized in the presence of a magnetic field. When an electrical current is applied to the coil 440, a magnetic field can develop in the coil 440, and the magnetic field can cause the core 442 to be attracted magnetically to a nearby ferrous body 446.

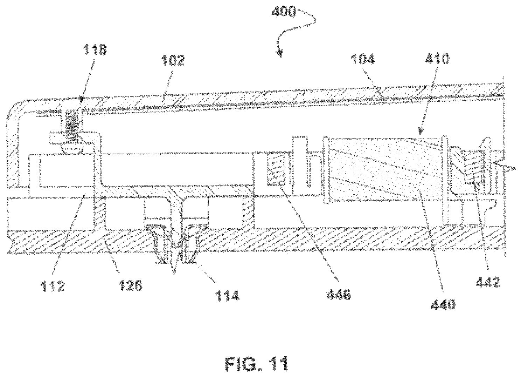

Referring to FIGS. 10 and 11, a touch panel assembly 400 is shown with the haptic effect generator 410 in different partial sectional views that show the arrangement of the coil 440, the core 442, and the ferrous body 446 relative to the bezel 102 and the rear cover 112. In the example shown, the touch panel assembly 400 can include a bezel 102, a sensor circuit board 104, a rear cover 112, at least one mounting 114, and at least one flex arm assembly 118. Also, the touch panel assembly 400 can be coupled to a structure 126, such as a dashboard of a vehicle. Turning to FIG. 10, the haptic effect generator 410 is shown in section so that most of the ferrous body 446 and a tip of the core 442 can be seen. The coil 440 and the core 442 can be coupled to the rear cover 112, and the ferrous body 446 can be coupled to the bezel 102. In the example shown, the ferrous body 446 can be held by supports 448 which are attached to a base 450, and the base 450 can be attached to the bezel 102 by screws 452. Turning to FIG. 11, the coil 440 and the core 442 are shown in another partial sectional view wherein a portion of the ferrous body 446 and a portion of the core 442 are shown in section. The coil 440 and the core 442 can be coupled to the rear cover 112. Thus, when the ferrous body 446 moves towards the core 442 because of the magnetic field generated by the coil 440, the bezel 102 can move with the ferrous body 446, and the bezel 102 can move relative to the rear cover 112. When the magnetic field collapses, the flex arm assembly 118 can pull the ferrous body 446 away from the core 442, and thus, the bezel 102 can return to substantially its original position before it moved.

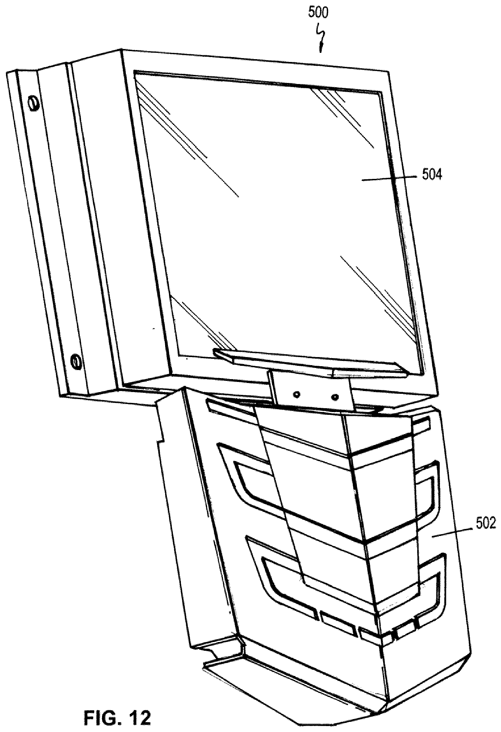

Referring to FIGS. 12-22, an assembly 500 is shown. Turning to FIG. 12, the assembly 500 can include a touch panel portion 502 and a display portion 504. The touch panel portion 502 and the display portion 504 can provide haptic feedback. In the embodiment shown, the touch panel portion 502 can be disposed below the display portion 504. The assembly 500 may be installed in the dashboard of a vehicle.

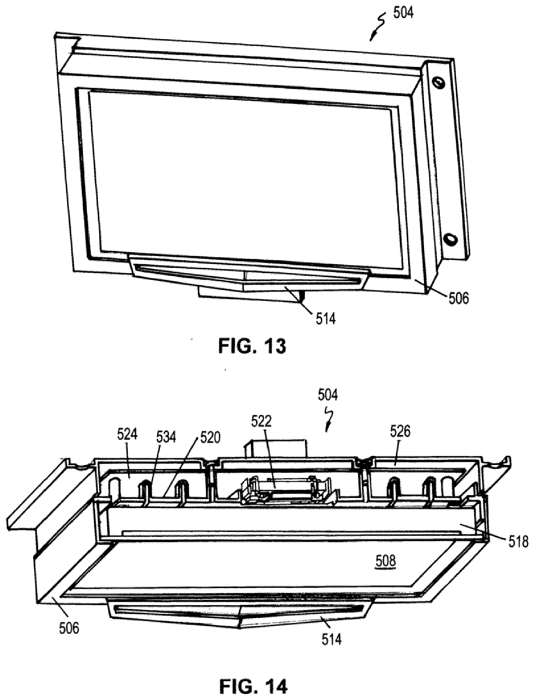

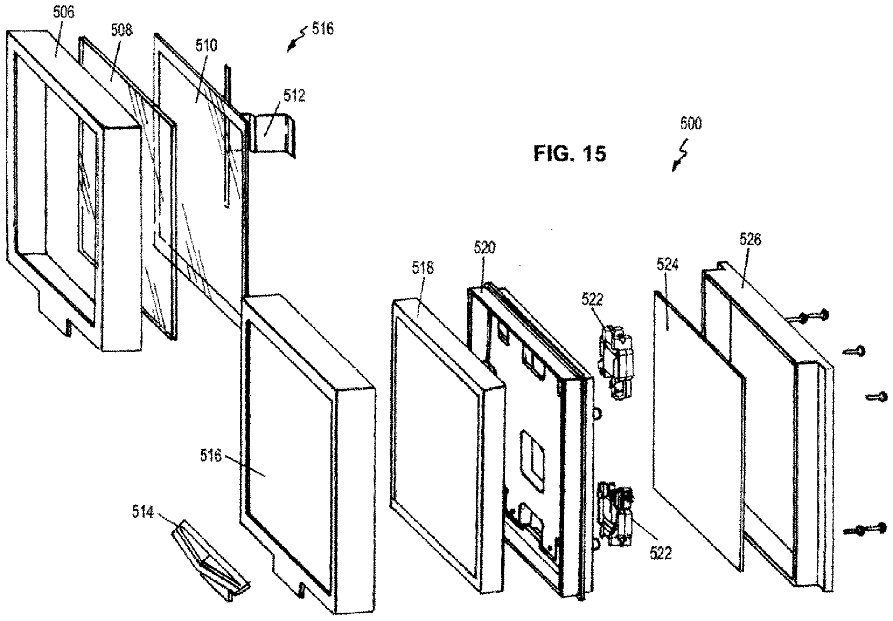

Referring to FIGS. 13-15, the display portion 502 of the assembly 500 is shown. The display portion 502 can provide images to which a user responds. The display portion 502 may also accept an input provided by the user. As best shown in FIG. 15, the display portion 504 can include a mount 506, a lens 508 disposed in the mount 506, a capacitive film 510 disposed behind the lens 508, a flexible printed circuit (FPC) ribbon 512, a slider assembly 514 disposed on an edge of the mount 506, a touch screen assembly 516, a display 518, a flexible frame 520, one or more haptic actuators 522 coupled to the flexible frame 520, a circuit board 524, and a rear cover 526.

The rear cover 526, the circuit board 524, and the display 518 can be coupled such that they do not move in response to the one or more haptic actuators 522. The display 518 can be a liquid crystal display. However, the touch screen assembly 516, the lens 508, and the capacitive film 510 can be coupled so that they move in response to the one or more haptic actuators 522. Alternatively, in other embodiments, one or more other components of the display portion 502 can be made to move or not move in response to one or more haptic actuators 522.

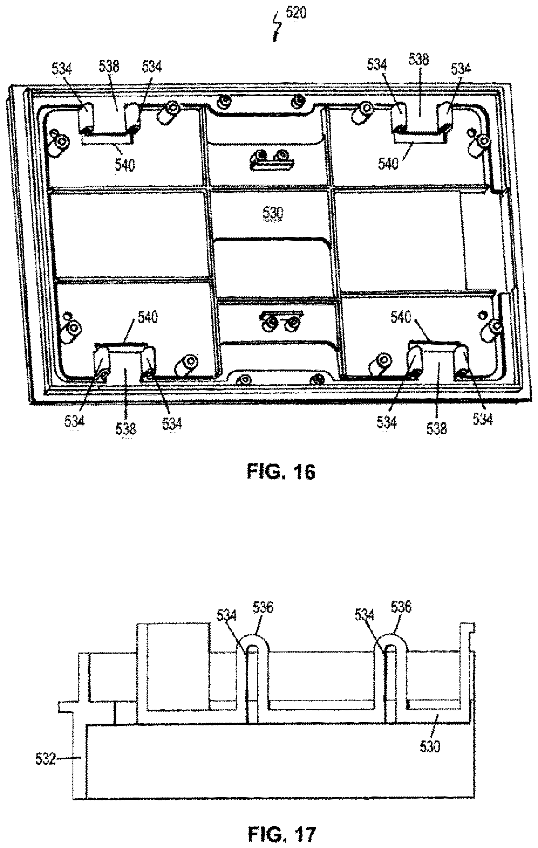

Referring to FIG. 16, the flex frame 520 includes a fixed portion 530 and a moveable portion 532. The moveable portion 532 can be adapted to move relative to the fixed portion 530 in response to one or more haptic actuators 522. In the embodiment shown, the fixed portion 530 can be formed as a panel, while the moveable portion 532 can be formed as a perimeter frame disposed substantially around and spaced apart from the panel. With the construction shown in FIG. 16, the flex frame 520 can be formed as a single molded component.

Referring to FIGS. 16 and 17, the flex frame 520 includes one or more flexible couplings 534 for coupling the fixed portion 530 and the moveable portion 532. The flexible couplings 534 are adapted to allow the moveable portion 532 to move relative to the fixed portion 530. The moveable portion 532 can include one or more extensions 538, and the fixed portion 530 can include one or more cutouts 540 to receive the one or extensions 538. The positions of the extensions 538 and the cutouts 540 in their respective moveable portion 532 or fixed portion 530 can determine the direction of movement of the moveable portion 532 relative to the fixed portion 530. In the embodiment shown, the flexible coupling 534 is formed integrally with the fixed portion 530 and the moveable portion 532. Also, the extensions 538 extend up or down from the moveable portion 532 relative to the figure, and the cutouts 540 are also disposed in the up and down direction of the figure. The flexible couplings 534 are disposed along the sides of the extensions 538 and its respective cutout 540. Thus, the moveable portion 532 can move to the left or right of the fixed portion 530. In other embodiments, the movable portion 532 can move in some other predetermined direction relative to the fixed portion 530. In order to provide the flexible coupling 534, a variety of structures, materials, or some combination of the aforementioned can be used. For example, the flexible coupling 534 can be made be a coiled spring, a ribbon spring, a tension or extension spring, a compression spring, a torsional spring, a cantilever spring, a loop (similar to loop 226), or some other structure that can be deformed and substantially return to its original shape. The flexible coupling 534 can be made from rubber, plastic, polymer, metal, alloy, or some other material that can be deformed and substantially return to its original shape. The flexible coupling 534 can be made separately or integrally with the fixed portion 530, the moveable portion 532, or both.

In the depicted embodiment, the flexible coupling 534 includes a loop 536 disposed between its couplings to the fixed portion 530 and the moveable portion 532. Also, in the embodiment shown, eight flexible couplings 534 can be disposed near the far corners of the fixed portion 530. However, the number of flexible couplings 534 is not meant to be limiting, and in other embodiments, there may be more or less than the eight flexible couplings 534 shown.

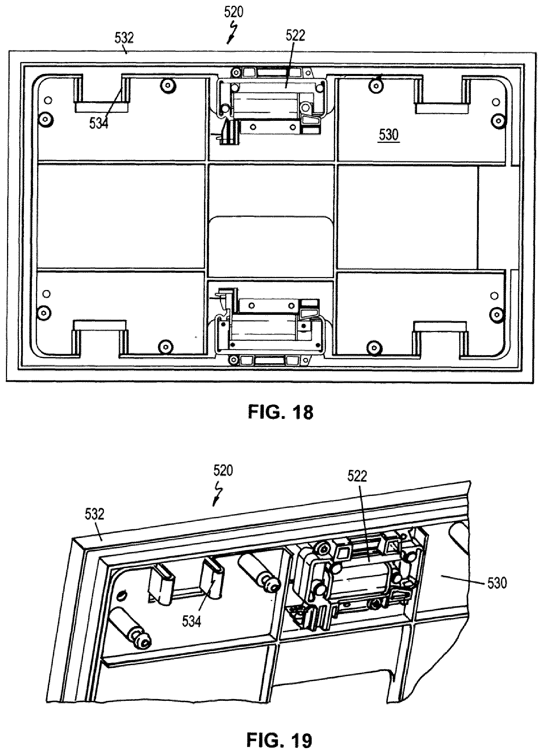

Referring to FIGS. 18-22, the flex frame 520 is shown coupled with a haptic actuator 522. The haptic actuator 522 can be coupled to the fixed portion 530 and the moveable portion 532. The haptic actuator 522 shown is substantially similar to haptic actuator 410, thus a detailed description thereof is omitted.

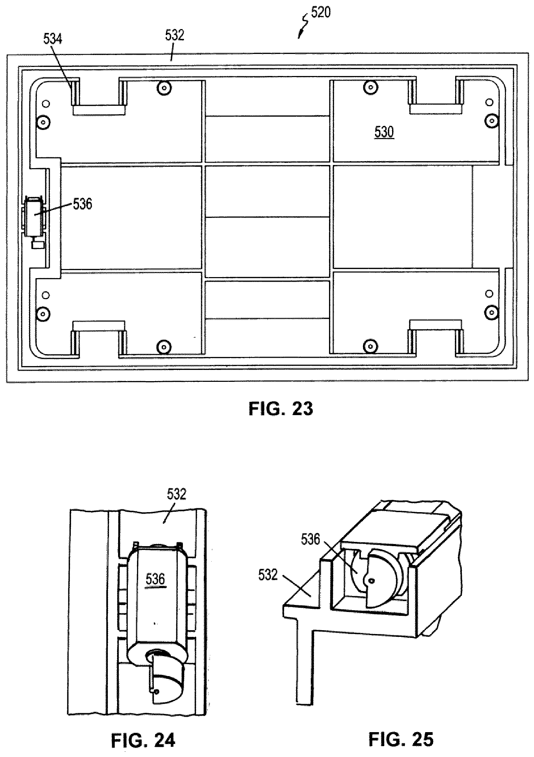

Referring to FIGS. 23-25, the flex frame 520 is shown coupled to another haptic actuator 536. In the example shown, the haptic actuator 536 is coupled only to the moveable portion 532. The depicted haptic actuator 536 is substantially similar to haptic effect generator 110, and thus a detailed description thereof is omitted.

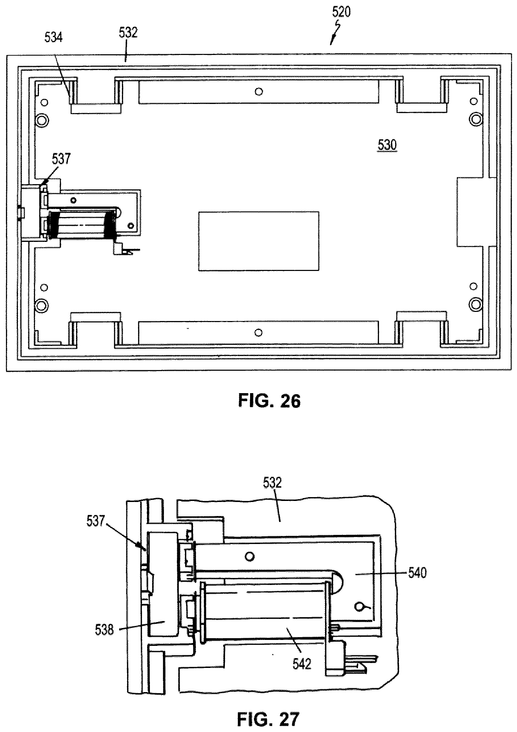

Referring to FIGS. 26-27, the flex frame 520 is shown coupled to yet another haptic actuator 537. In the embodiment shown, the haptic actuator 537 can be coupled to the fixed portion 530 and the moveable portion 532. The haptic actuator 537 can include a first ferrous body 538, a second ferrous body 540 disposed adjacent and spaced apart from the first ferrous body 538, and a coil 542 disposed around the second ferrous body 540. The coil 542 can be made of an electrically conductive material wrapped around the second ferrous body 538. The coil 542 can produce a magnetic field when an electrical current is applied to the coil 542. The first ferrous body 538 and the second ferrous body 540 can be made of a ferrous material or a material that can be magnetized in the presence of a magnetic field. When an electrical current is applied to the coil 542, a magnetic field can be developed in the coil 542, and the magnetic field can cause the second ferrous body 540 to be attracted magnetically to the nearby first ferrous body 538.

In the embodiment shown, the first ferrous body 538 can be coupled to the moveable portion 532, and the second ferrous body 540 can be coupled to the fixed portion 530. Thus, when the first ferrous body 538 moves towards the second ferrous body 540 because of the magnetic field generated by the coil 542, the moveable portion 532 can move with the first ferrous body 538, and the moveable portion 532 can move relative to the fixed portion 530. When the magnetic field collapses, the flexible couplings 534 can pull the first ferrous body 538 away from the second ferrous body 540, and thus, the moveable portion 532 can return to substantially its original position relative to the fixed portion 530 before it moved.

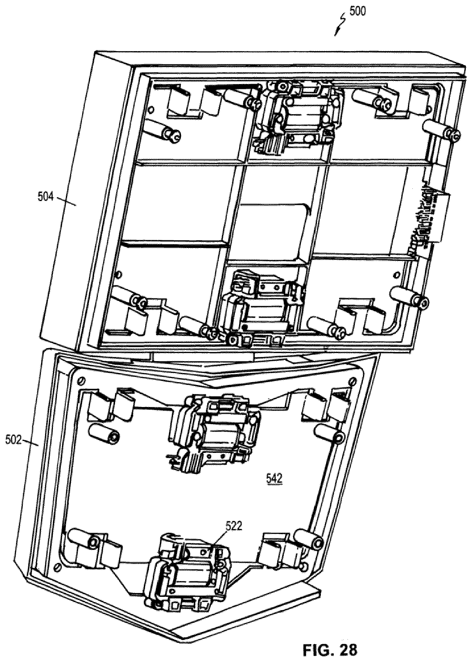

Referring to FIGS. 28-36, the touch panel portion 502 of the assembly 500 is shown. As shown in these figures, the touch panel portion 502 can include one or more haptic actuators 522 and a flex frame 542. The flex frame 542 is similar to the flex frame 520.

As apparent from the above description, the invention provides a touch panel assembly 100 with haptic effects and a method of manufacturing the touch panel assembly 100 with haptic effects. At least one haptic effect generator 110 and at least one flexible arm portion 122 are coupled to the touch panel assembly 100 so that a slight movement is imparted to the bezel 102 in response to the user manipulating an input device 116 disposed on the bezel 102. Thus, the haptic effect generator 110 and the flexible arm portion 122 provide a system with haptic feedback at reduced cost, with simpler manufacturing requirements at lower cost, and with reduced premature component failure.

While a particular embodiment has been chosen to illustrate the invention, it will be understood by those skilled in the art that various changes and modifications can be made therein without departing from the scope of the invention as defined in the appended claims.

## Claims

1. An assembly with haptic effects, the assembly comprising:
a panel (502) adapted to be coupled to a vehicle, the panel including one or more cutouts extending into the panel;
a frame (520) disposed around and spaced apart from the panel, the frame including one or more extensions (538) extending away from the frame and received by a respective one of the one or more cutouts (540);
at least one U-shaped flexible coupling (534) to couple the panel to the frame comprising a flexible member that is moulded as an integral part of the frame and the panel;
a haptic actuator (522) coupled to the frame and the panel such that movement generated by the haptic actuator is imparted through the frame to create haptic effects;
an input device coupled to the frame adapted to cause movement of the frame when an input is received; and
a display (518) coupled to the panel so as to be stationary with respect to the panel and disposed under the input device.

2. An assembly with haptic effects according to claim 1, wherein the at least one flexible coupling is disposed near the one or more extensions and its respective one or more cutouts.

3. An assembly with haptic effects according to any preceding claim, wherein the haptic actuator is a linear actuator.

4. An assembly with haptic effects according to any of claims 1 or 2, wherein the haptic actuator includes an eccentric rotary mass.

## Patentansprüche

1. Anordnung mit haptischen Effekten, wobei die Anordnung Folgendes umfasst:
eine Tafel (502), die zur Kopplung mit einem Fahrzeug eingerichtet ist, wobei die Tafel eine oder mehrere Aussparungen aufweist, die sich in die Tafel erstrecken,
einen Rahmen (520), der um die Tafel und von dieser beabstandet angeordnet ist, wobei der Rahmen einen oder mehrere Fortsätze (538) aufweist, die sich von dem Rahmen weg erstrecken und von einer entsprechenden der einen oder mehreren Aussparungen (540) aufgenommen sind,
wenigstens eine U-förmige, flexible Kopplung (534) zum Koppeln der Tafel mit dem Rahmen, die ein flexibles Element umfasst, das als integraler Teil des Rahmens und der Tafel geformt ist,
einen Haptik-Aktor (522), der so mit dem Rahmen und der Tafel gekoppelt ist, dass eine von dem Haptik-Aktor erzeugte Bewegung durch den Rahmen übertragen wird, um haptische Effekte zu schaffen,
eine Eingabevorrichtung, die mit dem Rahmen gekoppelt und so eingerichtet ist, dass sie bei Empfang einer Eingabe eine Bewegung des Rahmens hervorruft, und
eine Anzeige (518), die so mit der Tafel gekoppelt ist, dass sie bezüglich der Tafel ortsfest ist, und unter der Eingabevorrichtung angeordnet ist.

2. Anordnung mit haptischen Effekten gemäß Anspruch 1, bei der die wenigstens eine flexible Kopplung nahe dem einen oder den mehreren Fortsätzen und ihrer bzw. ihren entsprechenden einen oder mehreren Aussparungen angeordnet ist.

3. Anordnung mit haptischen Effekten gemäß einem vorhergehenden Anspruch, bei der der Haptik-Aktor ein Linearaktor ist.

4. Anordnung mit haptischen Effekten gemäß einem der Ansprüche 1 oder 2, bei der der Haptik-Aktor eine sich drehende Exzentermasse aufweist.

## Revendications

1. Ensemble à effets haptiques, l'ensemble comprenant :
un panneau (502) qui est apte à être couplé à un véhicule, le panneau présentant un ou plusieurs évidements qui s'étendent dans le panneau ;
un cadre (520) qui est agencé autour et à distance du panneau, le cadre présentant un ou plusieurs prolongements (538) qui s'étendent en éloignement du cadre et qui sont reçus par un évidement correspondant dudit un ou desdits plusieurs évidements (540) ;
au moins un accouplement flexible (534) en forme de U pour coupler le panneau au cadre, lequel comprend un élément flexible qui est moulé sous forme de pièce intégrale du cadre et du panneau ;
un actuateur d'haptique (522) qui est couplé au cadre et au panneau de sorte qu'un mouvement généré par l'actuateur d'haptique est communiqué à travers le cadre afin de créer des effets haptiques ;
un dispositif d'entrée qui est couplé au cadre et est apte à provoquer un mouvement du cadre lorsqu'une entrée est reçue ; et
un moyen d'affichage (518) qui est couplé au panneau de manière à être stationnaire par rapport au panneau et qui est agencé au-dessous du dispositif d'entrée.

2. Ensemble à effets haptiques selon la revendication 1, dans lequel ledit au moins un accouplement flexible est agencé à proximité dudit un ou desdits plusieurs prolongements et dudit un ou desdits plusieurs évidements correspondants de celui-ci.

3. Ensemble à effets haptiques selon l'une des revendications précédentes, dans lequel l'actuateur d'haptique est un actuateur linéaire.

4. Ensemble à effets haptiques selon l'une des revendications 1 ou 2, dans lequel l'actuateur d'haptique présente une masse excentrique rotative.
